# EUROPEAN PATENT SPECIFICATION

(11) **EP 3 803 993 B1**
(45) Date of publication and mention of the grant of the patent: **24.08.2022**
(21) Application number: 18733441.2
(22) Date of filing: 31.05.2018
(51) Int. Cl.: H01L 45/00, H01L 27/24

(54) **PHASE CHANGE MEMORY STRUCTURES AND DEVICES**
PHASENWECHSELSPEICHERSTRUKTUREN UND -VORRICHTUNGEN
STRUCTURES ET DISPOSITIFS DE MÉMOIRE À CHANGEMENT DE PHASE

(43) Date of publication of application: 14.04.2021
(73) Proprietor: INTEL Corporation, Santa Clara, CA 95054 (US)
(72) Inventor: FUGAZZA, Davide, San Jose, California 95134 (US); RUSSELL, Stephen, Boise, Idaho 83716 (US); JIN, Yao, Meridian, Idaho 83646 (US); REDAELLI, Andrea, 23880 Casatenovo (IT); ZHENG, Pengyuan, Boise, Idaho 83707 (US); HU, Yongiun J., Boise, Idaho 83716 (US)
(74) Representative: Rummler, Felix
(86) International application number: PCT/US2018/035472
(87) International publication number: WO 2019/231460

(56) References cited:
- WO-A1-2013/039496
- US-A1- 2008 090 400
- US-A1- 2015 084 156

## Description

### BACKGROUND

Phase change materials have properties that invite their use in a number of applications such as ovonic threshold switches and phase change memory (PCM).

Different physical states of the phase change material have different levels of electrical resistance. For example, one state, such as an amorphous state, can have a high electrical resistance, while another state, such as a crystalline state, can have a low electrical resistance. In PCM, these different levels of electrical resistance can be used to store binary information. Each state is designated a different binary value, and once stored, information can be read by detecting the electrical resistance of the material. The fact that each state persists once fixed makes PCM a valuable non-volatile memory (NVM) type.

US 2015/0084156 A1 mentions the possibility of using CN as an electrode material in a PCM element. Bit lines are formed directly over the electrode layer overlaying the memory element.

The provision of a ceramic layer over the memory cell is known from, for example, WO 2013/039496 A. There a ceramic dielectric layer 118 is formed over the electrode on the PCM element.

US 2008/0090400 A1 shows the use of a conductive ceramic as a conductive heat insulating layer directly above the PCM material as an electric contact to an overlying conductive block / electrode.

### BRIEF DESCRIPTION OF THE DRAWINGS

FIG. 1A illustrates a phase change memory (PCM) cell, in accordance with an example embodiment;
FIG. 1B illustrates a PCM cell, in accordance with an example embodiment;
FIG. 1C illustrates a PCM cell, in accordance with an example embodiment;
FIG. 2 illustrates a PCM cell, in accordance with an example embodiment;
FIG. 3A illustrates a PCM device, in accordance with an example embodiment;
FIG. 3B illustrates an alternate view of the PCM device of FIG. 3A, in accordance with an example embodiment; and
FIG. 4 illustrates a computing system, in accordance with an example embodiment.

### DESCRIPTION OF EMBODIMENTS

Although the following detailed description contains many specifics for the purpose of illustration, a person of ordinary skill in the art will appreciate that many variations and alterations to the following details can be made and are considered to be included herein. Accordingly, the following embodiments are set forth without any loss of generality to, and without imposing limitations upon, any claims set forth. It is also to be understood that the terminology used herein is for the purpose of describing particular embodiments only, and is not intended to be limiting. Unless defined otherwise, all technical and scientific terms used herein have the same meaning as commonly understood by one of ordinary skill in the art to which this disclosure belongs.

As used in this written description, the singular forms "a," "an" and "the" include express support for plural referents unless the context clearly dictates otherwise. Thus, for example, reference to "a layer" includes a plurality of such layers.

In this application, "comprises," "comprising," "containing" and "having" and the like can mean "includes," "including," and the like, and are generally interpreted to be open ended terms. The terms "consisting of' or "consists of' are closed terms, and include only the components, structures, steps, or the like specifically listed in conjunction with such terms. "Consisting essentially of' or "consists essentially of' have the meaning generally ascribed to them.

In particular, such terms are generally closed terms, with the exception of allowing inclusion of additional items, materials, components, steps, or elements, that do not materially affect the basic and novel characteristics or function of the item(s) used in connection therewith. For example, trace elements present in a composition, but not affecting the compositions nature or characteristics would be permissible if present under the "consisting essentially of' language, even though not expressly recited in a list of items following such terminology. When using an open-ended term, like "comprising" or "including," in this written description it is understood that direct support should be afforded also to "consisting essentially of' language as well as "consisting of' language as if stated explicitly and vice versa.

The terms "first," "second," "third," "fourth," and the like in the description and in the claims, if any, are used for distinguishing between similar elements and not necessarily for describing a particular sequential or chronological order. It is to be understood that any terms so used are interchangeable under appropriate circumstances such that the embodiments described herein are, for example, capable of operation in sequences other than those illustrated or otherwise described herein. Similarly, if a method is described herein as comprising a series of steps, the order of such steps as presented herein is not necessarily the only order in which such steps may be performed, and certain of the stated steps may possibly be omitted and/or certain other steps not described herein may possibly be added to the method.

The terms "left," "right," "front," "back," "top," "bottom," "over," "under," and the like in the description and in the claims, if any, are used for descriptive purposes and not necessarily for describing permanent relative positions. It is to be understood that the terms so used are interchangeable under appropriate circumstances such that the embodiments described herein are, for example, capable of operation in other orientations than those illustrated or otherwise described herein.

As used herein, comparative terms such as "increased," "decreased," "better," "worse," "higher," "lower," "enhanced," "minimized," "maximized," "increased," "decreased," "reduced," and the like refer to a property of a device, component, function, or activity that is measurably different from other devices, components, or activities in a surrounding or adjacent area, in a single device to which comparison can be made, or in multiple comparable devices, in a group or class, in multiple groups or classes, related or similar processes or functions, or as compared to the known state of the art. For example, a data region that has an "increased" risk of corruption can refer to a region of a memory device, which is more likely to have write errors to it than other regions in the same memory device. A number of factors can cause such increased risk, including location, fabrication process, number of program pulses applied to the region, etc.

The term "coupled," as used herein, is defined as directly or indirectly connected in an electrical or nonelectrical manner. "Directly coupled" structure or elements are in direct contact and attached. Objects described herein as being "adjacent to" each other may be in physical contact with each other, in close proximity to each other, or in the same general region or area as each other, as appropriate for the context in which the phrase is used.

As used herein, the term "substantially" refers to the complete or nearly complete extent or degree of an action, characteristic, property, state, structure, item, or result. For example, an object that is "substantially" enclosed would mean that the object is either completely enclosed or nearly completely enclosed. The exact allowable degree of deviation from absolute completeness may in some cases depend on the specific context. However, generally speaking the nearness of completion will be so as to have the same overall result as if absolute and total completion were obtained. The use of "substantially" is equally applicable when used in a negative connotation to refer to the complete or near complete lack of an action, characteristic, property, state, structure, item, or result. For example, a composition that is "substantially free of' particles would either completely lack particles, or so nearly completely lack particles that the effect would be the same as if it completely lacked particles. In other words, a composition that is "substantially free of' an ingredient or element may still actually contain such item as long as there is no measurable effect thereof.

As used herein, the term "about" is used to provide flexibility to a numerical range endpoint by providing that a given value may be "a little above" or "a little below" the endpoint. Unless otherwise stated, use of the term "about" in accordance with a specific number or numerical range should also be understood to provide support for such numerical terms or range without the term "about". For example, for the sake of convenience and brevity, a numerical range of "about 50 angstroms to about 80 angstroms" should also be understood to provide support for the range of "50 angstroms to 80 angstroms." Furthermore, it is to be understood that in this specification support for actual numerical values is provided even when the term "about" is used therewith. For example, the recitation of "about" 30 should be construed as not only providing support for values a little above and a little below 30, but also for the actual numerical value of 30 as well.

As used herein, the term "amorphous" is used to refer to a material having a degree of amorphosity. By "degree of amorphosity," it is meant that a given material is at least partially amorphous. Thus, the term "amorphous" can refer to a material that is at least partially amorphous or a material that is substantially, or completely, amorphous. In some embodiments, a given material, such as CNₓ, or a chalcogenide, can be at least 50% amorphous. In other examples, the material can be at least 70% amorphous. In still other examples, the material can be at least 80% amorphous. In further examples, the material can be at least 90% amorphous. In still further examples, the material can be at least 95% amorphous, at least 98% amorphous or even 100% amorphous.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary.

Concentrations, amounts, and other numerical data may be expressed or presented herein in a range format. It is to be understood that such a range format is used merely for convenience and brevity and thus should be interpreted flexibly to include not only the numerical values explicitly recited as the limits of the range, but also to include all the individual numerical values or sub-ranges encompassed within that range as if each numerical value and sub-range is explicitly recited. As an illustration, a numerical range of "about 1 to about 5" should be interpreted to include not only the explicitly recited values of about 1 to about 5, but also include individual values and sub-ranges within the indicated range. Thus, included in this numerical range are individual values such as 2, 3, and 4 and sub-ranges such as from 1-3, from 2-4, and from 3-5, etc., as well as 1, 2, 3, 4, and 5, individually.

This same principle applies to ranges reciting only one numerical value as a minimum or a maximum. Furthermore, such an interpretation should apply regardless of the breadth of the range or the characteristics being described.

Reference throughout this specification to "an example" means that a particular feature, structure, or characteristic described in connection with the example is included in at least one embodiment. Thus, appearances of the phrases "in an example" in various places throughout this specification are not necessarily all referring to the same embodiment.

### Example Embodiments

An initial overview of technology embodiments is provided below and specific embodiments are then described in further detail. This initial summary is intended to aid readers in understanding the technological concepts more quickly, but is not intended to identify key or essential features thereof, nor is it intended to limit the scope of the claimed subject matter.

Phase change memory (PCM) devices have been developed to include an array of memory cells connected to bitlines and wordlines, for example, byte-addressable, write-in-place non-volatile memory (NVM) such as three-dimensional (3D) cross-point memory. In many cases, each phase change memory cell is made up of a number of layers of different materials. Such layers can include a phase change material, electrodes, select device materials, diffusion barrier materials, thermal insulating materials, and so on. In some cases, individual memory cells can be separated by dielectric materials to electrically insulate the memory cells one from another. Bitlines and wordlines can be a line of metal or other conductive material deposited along columns and rows of memory cells to allow the memory cells to be individually addressable. Additional structures are sometimes incorporated into the memory array such as conductive vias that penetrate through the substrate on which the memory array is formed.

The various material layers and structures that make up a phase change memory device can present various operational and manufacturing challenges. For example, it can be desirable to make these structures as small as possible in order to make high-density memory. Further, it can be desirable to maximize operational efficiency of individual memory cells. However, this can be balanced against processing limitations and the need for consistent and reliable memory operation.

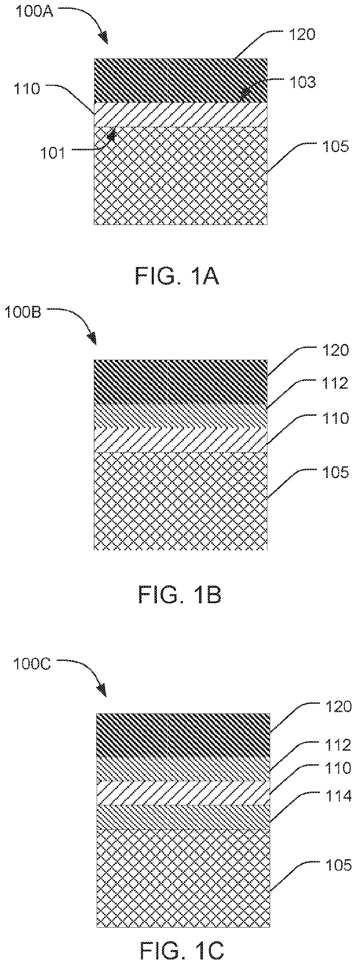

The present disclosure describes PCM cells, structures, devices, systems, and associated methods that can provide good cell programming efficiency and that can minimize resistivity at the interface between an electrode and a metal ceramic composite material layer to maintain or maximize product yield. In further detail, PCM cells, as described herein, can include a PCM material layer, a metal ceramic composite material layer, and an amorphous carbon nitride (CNₓ, wherein x is an atomic ratio of N) electrode layer positioned between the PCM material layer and the metal ceramic composite material layer. This can be further illustrated in FIGs. 1A-1C.

For example, FIG. 1A illustrates a PCM cell 100A having a PCM material layer 105, an amorphous CNₓ electrode layer 110, and a metal ceramic composite material layer 120. In this particular example, the amorphous CNₓ electrode layer 110 is positioned in direct contact with the PCM material layer 105 and the metal ceramic composite material layer 120. The amorphous CNₓ electrode layer 110 can form a first electrode (or a CNₓ electrode). It is noted that the amorphous CNₓ electrode layer 110 can typically have a higher resistivity than a carbon electrode layer, which can increase the cell programming efficiency of the PCM cell relative to a carbon electrode layer. To maintain a suitable metal ceramic composite material layer interface, the nitrogen content in the amorphous CNₓ electrode layer 110 can be graded from a higher nitrogen content or concentration at a PCM material layer side 101 to a lower nitrogen content or concentration at an opposite side 103 proximate the metal ceramic composite material layer 120 (i.e. the metal ceramic composite material layer interface). Thus, the amorphous CNₓ electrode layer can provide high resistivity to maximize cell programming efficiency while maintaining a suitable metal ceramic composite material layer interface to maintain or maximize product yield.

FIG. 1B illustrates an alternative configuration of a PCM cell 100B having a PCM material layer 105, an amorphous CNₓ electrode layer 110, an upper barrier layer 112, and a metal ceramic composite material layer 120. The amorphous CNₓ electrode layer 110 and the upper barrier layer 112 can form a first electrode (or a CNₓ electrode). In this particular example, the amorphous CNₓ electrode layer 110 can have a graded nitrogen content, as described with respect to PCM cell 100A, or a uniform, or substantially uniform, composition. For example, in some cases, the upper barrier layer 112 can provide a suitable metal ceramic composite material layer interface without grading the nitrogen content of the amorphous CNₓ electrode layer 110. Thus, the amorphous CNₓ electrode layer 110 can minimize programming current due to its higher bulk resistivity and the upper barrier layer 112 can minimize the resistivity at the metal ceramic composite material layer interface. However, it is emphasized that an upper barrier layer 112 can be used whether the amorphous CNₓ electrode layer 110 has a gradient composition or a uniform composition, as desired.

FIG. 1C illustrates yet another example of a PCM cell 100C having a PCM material layer 105, an amorphous CNₓ electrode layer 110, an upper (or first upper) barrier layer 112, a lower (or first lower) barrier layer 114, and a metal ceramic composite material layer 120. In this example, an upper barrier layer 112 and a lower barrier layer 114 are positioned on opposite sides of the amorphous CNₓ electrode layer 110. The amorphous CNₓ electrode layer 110, the upper barrier layer 112, and the lower barrier layer 114 can form a first electrode (or a CNₓ electrode). As described with respect to the PCM cell 100B, the amorphous CNₓ electrode layer 110 can have a graded composition or a uniform, or substantially uniform, composition. For example, in some cases, the upper barrier layer 112 can provide a suitable metal ceramic composite material layer interface without grading the composition of the amorphous CNₓ electrode layer 110. Thus, the amorphous CNₓ electrode layer 110 can minimize programming current due to its higher bulk resistivity and the upper barrier layer 112 can minimize the resistivity at the metal ceramic composite material layer interface. In this particular example, the PCM cell 100C can further include a lower barrier layer 114, which can provide additional thermal stability to the PCM cell and minimize diffusion of the PCM material into the amorphous CNₓ electrode layer. While not illustrated in this particular example, the upper barrier layer 112 can be removed from PCM cell 100C where the amorphous CNₓ electrode layer has a graded composition, as described with respect to PCM cell 100A. Thus, in some examples, the PCM cell can include an amorphous CNₓ electrode layer 110 and a lower barrier layer 114 without the upper barrier layer 112. It is again emphasized that an upper barrier layer 112, a lower barrier layer 114, or both can be used in combination with the amorphous CNₓ electrode layer 110 whether the amorphous CNₓ electrode layer has a gradient composition or a uniform composition, as desired.

In further examples, an additional CNₓ electrode layer (not illustrated) can also be included between the lower barrier layer 114 and the PCM material layer 105. This additional CNₓ electrode layer can have either a graded nitrogen content or a uniform composition, as desired. In some examples, the additional CNₓ electrode layer can also be amorphous.

In further detail, the PCM material layer in the PCM cell can include one or more of a variety of PCM materials. As a general matter, the phase change material can include any useful material having a stable and detectable change in phase. In some examples, the phase change material can include germanium, antimony, tellurium, silicon, nickel, gallium, arsenic, silver, tin, gold, lead, bismuth, indium, yttrium, selenium, scandium, boron, oxygen, sulphur, nitrogen, carbon, the like, or a combination thereof. Specific examples of such a materials can include any of a variety of chalcogenides or chalcogenide alloys, including, without limitation, Ge-Te, In-Se, Sb-Te, Ge-Sb, Ga-Sb, In-Sb, As-Te, Al-Te, Ge-Sb-Te, Te-Ge-As, In-Sb-Te, In-Se-Te, Te-Sn-Se, Ge-Se-Ga, Bi-Se-Sb, Ga-Se-Te, Sn-Sb-Te, In-Sb-Ge, Te-Ge-Sb-S, Te-Ge-Sn-O, Te-Ge-Sn-Au, Pd-Te-Ge-Sn, In-Se-Ti-Co, Ge-Sb-Te-Pd, Ge-Sb-Te-Co, Sb-Te-Bi-Se, Ag-In-Sb-Te, Ge-Sb-Se-Te, Ge-Sn-Sb-Te, Ge-Te-Sn-Ni, Ge-Te-Sn-Pd, and Ge-Te-Sn-Pt, among others. The hyphenated chemical composition notation, as used herein, indicates the elements included in a particular mixture or compound, e.g., chalcogenide alloy, and is intended to represent all stoichiometries involving the indicated elements, e.g., Ge_{X}Sb_{Y}Te_{Z} having variations in stoichiometries, such as Ge₂Sb₂Te₅, Ge₂Sb₂Te₇, Ge₁Sb₂Te₄, Ge₁Sb₄Te₇, etc., to form a gradient. In some additional examples, the chalcogenide alloy can be doped, such as with indium, yttrium, scandium, boron, nitrogen, oxygen, the like, or a combination thereof.

The metal ceramic composite material layer can include various combinations of metal ceramic composite materials. In some examples, the metal ceramic composite material can include tungsten, titanium, tantalum, or the like (e.g. refractory metals, or the like, for example) in combination with silicon, carbon, nitrogen, boron, oxygen, the like, or a combination thereof. In some examples, the metal ceramic composite material can include any suitable cermet material. In some specific examples, the metal ceramic composite material can include tungsten silicon nitride, tantalum silicon nitride, niobium silicon nitride, molybdenum silicon nitride, titanium silicon nitride, carbon nitride, tungsten carbon nitride, doped alpha silicon, doped alpha germanium, the like, or a combination thereof. In some further examples, the metal ceramic composite material can include tungsten silicon nitride (WSiN).

The amorphous CNₓ electrode layer can include a variety of compositions. For example, in some cases, the amorphous CNₓ electrode layer can have a uniform or substantially uniform composition. Where this is the case, nitrogen can typically be present in the amorphous CNₓ electrode layer at an atomic percent (at%) of from about 0.1 at% to about 35 at%. In other examples, nitrogen can be present in the CNₓ electrode layer in an amount from about 0.5 at% to about 30 at%. In still other examples, nitrogen can be present in the CNₓ electrode layer in an amount from about 1 at% to about 25 at%.

As discussed previously, in some examples the amorphous CNₓ electrode layer can have a gradient composition. For example, in some cases, the amorphous CNₓ electrode layer can have a nitrogen concentration of from about 15 at% to about 35 at% at a PCM material layer side of the amorphous CNₓ electrode layer proximate the PCM material layer transitioning to a nitrogen concentration of from about 0.1 at% to about 1 at% at an opposite side thereof proximate the metal ceramic composite material layer. In some other examples, the amorphous CNₓ electrode layer can have a nitrogen concentration of from about 20 at% to about 30 at% at a PCM material layer side of the amorphous CNₓ electrode layer proximate the PCM material layer transitioning to a nitrogen concentration of from about 0.3 at% to about 3 at% at an opposite side thereof proximate the metal ceramic composite material layer. In yet other examples, the amorphous CNₓ electrode layer can have a nitrogen concentration of from about 25 at% to about 40 at% at a PCM material layer side of the amorphous CNₓ electrode layer proximate the PCM material layer transitioning to a nitrogen concentration of from about 0.5 at% to about 5 at% at an opposite side thereof proximate the metal ceramic composite material layer. Other suitable ranges of nitrogen content in the amorphous CNₓ electrode layer can also be used. In some examples, the gradient concentration can be formed in the opposite direction (i.e. from the opposite side proximate the metal ceramic composite material layer transitioning to the PCM material layer side). Where this is the case, the same ranges can apply in the opposite direction (e.g. from about 15 at% to about 35 at% nitrogen at the opposite side of the amorphous CNₓ electrode layer proximate the metal ceramic composite material layer transitioning to a nitrogen concentration of from about 0.1 at% to about 1 at% at the PCM material side proximate the PCM material layer, etc.).

Where the amorphous CNₓ electrode layer has a gradient composition, a variety of gradient compositions can be used. In some examples, the gradient can be a step gradient including one or more distinct concentration changes (e.g. 1 concentration step, 2 concentration steps, 3 concentration steps, etc.). In some other examples, the gradient can be a continuous gradient, such as a linear, or substantially linear, gradient, a parabolic gradient, or other suitable continuous gradient.

The amorphous CNₓ electrode layer can have a variety of thicknesses, depending on the desired electrical properties of the layer, the composition of the layer, etc. In some examples, the CNₓ electrode layer can have a thickness of from about 1 nanometer (nm) to about 30 nm. In other examples, the CNₓ electrode layer can have a thickness of from about 2 nm to about 20 nm.

The amorphous CNₓ electrode layer can have a variety of electrical resistivities. For examples, in some cases, the amorphous CNₓ electrode layer can have a tunable electrical resistivity at room temperature of from about 1 mOhm-cm to about 2000 mOhm-cm and a tunable electrical resistivity at 650 °C of from about 1 mOhm-cm to about 100 mOhm-cm. In some other examples, the amorphous CNₓ electrode layer can have a tunable electrical resistivity at room temperature of from about 5 mOhm-cm to about 1000 mOhm-cm and a tunable electrical resistivity at 650 °C of from about 5 mOhm-cm to about 50 mOhm-cm.

Whether the CNₓ electrode layer has a uniform composition or a gradient composition, the PCM cell can optionally further include an upper barrier layer, a lower barrier layer, or both. The upper and lower barrier layers can have a variety of thicknesses. In some examples, the upper barrier layer can have a thickness of from about 2 nm to about 20 nm, or from about 3 nm to about 10 nm. Similarly, the lower barrier layer can have a thickness of from about 2 nm to about 20 nm, or from about 3 nm to about 10 nm. However, where both an upper and a lower barrier layer are employed, it is noted that the two layers need not have the same thickness.

The upper barrier layer and the lower barrier layer can also include a variety of materials. In some examples, the upper barrier layer and the lower barrier layer can include carbon (C), n-doped polysilicon, p-doped polysilicon, metals (e.g. Al, Cu, Ni, Cr, Co, Ru, Rh, Pd, Ag, Pt, Au, Ir, Ta, and W, for example), the like, or a combination thereof. In some specific examples, the upper barrier layer, the lower barrier layer, or both are formed of a carbon material. Non-limiting examples of suitable carbon materials can include amorphous carbon, crystalline carbon, graphitic carbon, nanostructured caron, diamond-like carbon, nanodiamond, boron-doped carbon, the like, or a combination thereof.

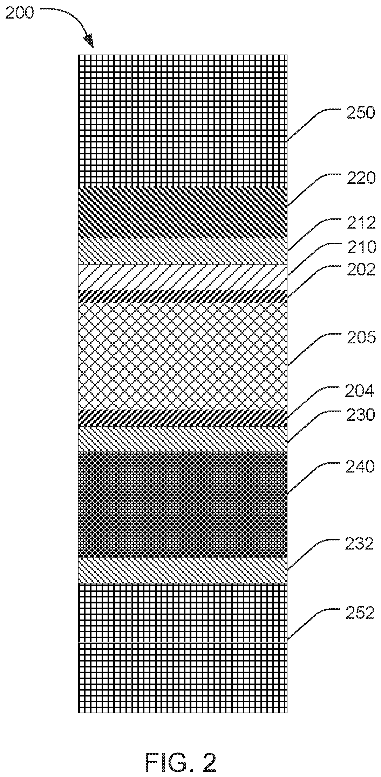

The PCM cell can include a variety of additional components, as desired. Some non-limiting examples are illustrated in FIG. 2, which can also represent a PCM structure. As described above, a PCM cell 200 can include a PCM material layer 205. The PCM cell can also include an amorphous CNₓ electrode layer 210, an upper barrier layer 212, and a metal ceramic composite material layer 220. The amorphous CNₓ electrode layer 210 and the upper barrier layer 212 can form a first electrode or a CNₓ electrode. The amorphous CNₓ electrode layer 210 can have a graded nitrogen content or a uniform nitrogen content, as desired.

The PCM cell 200 can also include an upper or first lamina layer 202 and/or a lower or second lamina layer 204 disposed on opposite sides, or either side, of the PCM layer 205. These lamina layers can be adhesion layers or can otherwise facilitate a good electrical connection between the PCM layer 205 and the surrounding electrode layers 210, 230. The lamina layers can be formed of a variety of materials. Non-limiting examples can include tungsten, tantalum, titanium, the like, or a combination thereof.

The PCM cell 200 can also include a second electrode 230. The second electrode can include one or more conductive or semiconductive materials. Non-limiting examples can include carbon (C), carbon nitride (CₓN_{y}), n-doped polysilicon, p-doped polysilicon, metals (e.g. Al, Cu, Ni, Cr, Co, Ru, Rh, Pd, Ag, Pt, Au, Ir, Ta, and W, for example), conductive metal nitrides, (e.g. TiN, TaN, WN, and TaCN, for example) conductive metal silicides (e.g. tantalum silicides, tungsten silicides, nickel silicides, cobalt silicides, and titanium silicides, for example), conductive metal silicides nitrides (e.g. TiSiN and WSiN, for example), conductive metal carbide nitrides (e.g. TiCN and WCN, for example), conductive metal oxides (e.g. RuO₂, for example), the like, or a combination thereof.

In some examples, the second electrode can also include a second CNₓ electrode layer. In some examples, the second CNₓ electrode layer can also be amorphous. In other examples, it may be desirable for the second CNₓ electrode layer to be crystalline. The parameters of the second CNₓ electrode layer can generally include the same parameters as described with respect to the CNₓ electrode layer of the first electrode. For example, in some cases, the second CNₓ electrode layer can have a substantially uniform composition. In some examples, as described with respect to the amorphous CNₓ electrode layer of the first electrode, the second CNₓ electrode layer can have a gradient composition from about 15 at% to about 35 at% nitrogen at a select device layer side proximate a select device layer, for example, transitioning to about 0.1 at% to about 1 at% nitrogen at an opposite side proximate the PCM material layer, or other suitable ranges as described with respect to the first electrode. In some examples, as described with respect to the amorphous CNₓ electrode layer of the first electrode, the gradient concentration can be formed in the opposite direction (i.e. from the opposite side proximate the PCM layer transitioning to the SD layer side). Where this is the case, the same ranges can apply in the opposite direction (e.g. from about 15 at% to about 35 at% nitrogen at the opposite side of the second CNₓ electrode layer proximate the PCM material layer transitioning to a nitrogen concentration of from about 0.1 at% to about 1 at% at the SD layer side proximate the SD layer, or other ranges as described with respect to the first electrode). However, where used, the second CNₓ electrode layer need not have the same composition, thickness, etc. as the amorphous CNₓ electrode layer of the first electrode. In some further examples, the second electrode can also include a second upper barrier layer, a second lower barrier layer, or both. The parameters of these barrier layers can also generally include the same parameters as described with respect to the upper barrier layer and the lower barrier layer of the first electrode. However, any barrier layers employed in the first electrode need not have the same composition, thickness, etc. as any barrier layers employed in the second electrode. The second upper barrier layer can be positioned between the second CNₓ electrode layer and the PCM material layer. The second lower barrier layer can be positioned between the second CNₓ electrode layer and a wordline. In some examples, additional CNₓ electrode layers can also be included in the second electrode. Where this is the case, an intervening barrier layer (e.g. the second upper barrier layer or the second lower barrier layer) can typically be positioned between CNₓ electrode layers.

The PCM cell 200 can also include a select device (SD) layer 240. It is noted that the select device material is generally made of a chalcogenide material, and as such, the materials described herein with respect to the PCM material layer are applicable here as well. The actual material used in a given memory structure for the PCM material layer and the SD layer can be different or the same, depending on the design of the device. In another example, the select device material in the SD layer can be a conductor, semiconductor, or dielectric material. Such materials can be selected as needed to perform an intended function in the phase change memory cell.

The PCM cell 200 can also include a third electrode 232. The third electrode can include one or more conductive or semiconductive materials. Non-limiting examples can include carbon (C), carbon nitride (CₓN_{y}), n-doped polysilicon, p-doped polysilicon, metals (e.g. Al, Cu, Ni, Cr, Co, Ru, Rh, Pd, Ag, Pt, Au, Ir, Ta, and W, for example), conductive metal nitrides, (e.g. TiN, TaN, WN, and TaCN, for example) conductive metal silicides (e.g. tantalum silicides, tungsten silicides, nickel silicides, cobalt silicides, and titanium silicides, for example), conductive metal silicides nitrides (e.g. TiSiN and WSiN, for example), conductive metal carbide nitrides (e.g. TiCN and WCN, for example), conductive metal oxides (e.g. RuO₂, for example), the like, or a combination thereof.

In some examples, the third electrode can also include a third CNₓ electrode layer. In some examples, the third CNₓ electrode layer can also be amorphous. However, in some examples, it may be desirable for the third CNₓ electrode layer to be crystalline. The parameters of the third CNₓ electrode layer can generally include the same parameters as described with respect to the amorphous CNₓ electrode layer of the first electrode. For example, in some cases, the third CNₓ electrode layer can have a substantially uniform composition. In some examples, as described with respect to the amorphous CNₓ electrode layer of the first electrode, the third CNₓ electrode layer can have a gradient composition from about 15 at% to about 35 at% nitrogen at a wordline side proximate a wordline, for example, transitioning to about 0.1 at% to about 1 at% nitrogen at an opposite side proximate the SD layer, or other suitable ranges as described with respect to the first electrode. In some examples, as described with respect to the amorphous CNₓ electrode layer of the first electrode, the gradient concentration can be formed in the opposite direction (i.e. from the opposite side proximate the SD layer transitioning to the wordline side). Where this is the case, the same ranges can apply in the opposite direction (e.g. from about 15 at% to about 35 at% nitrogen at the opposite side of the third CNₓ electrode layer proximate the SD layer transitioning to a nitrogen concentration of from about 0.1 at% to about 1 at% at the wordline side proximate the wordline, or other ranges as described with respect to the first electrode). However, where used, the third CNₓ electrode layer need not have the same composition, thickness, etc. as the amorphous CNₓ electrode layer of the first electrode. In some further examples, the third electrode can also include a third upper barrier layer, a third lower barrier layer, or both. The parameters of these barrier layers can also generally include the same parameters as described with respect to the upper barrier layer and the lower barrier layer of the first electrode. However, any barrier layers employed in the first electrode need not have the same composition, thickness, etc. as any barrier layers employed in the third electrode. The third upper barrier layer can be positioned between the third CNₓ electrode layer and the PCM material layer. The third lower barrier layer can be positioned between the third CNₓ electrode layer and a wordline. In some examples, additional CNₓ electrode layers can also be included in the third electrode. Where this is the case, an intervening barrier layer (e.g. the third upper barrier layer or the third lower barrier layer) can typically be positioned between CNₓ electrode layers.

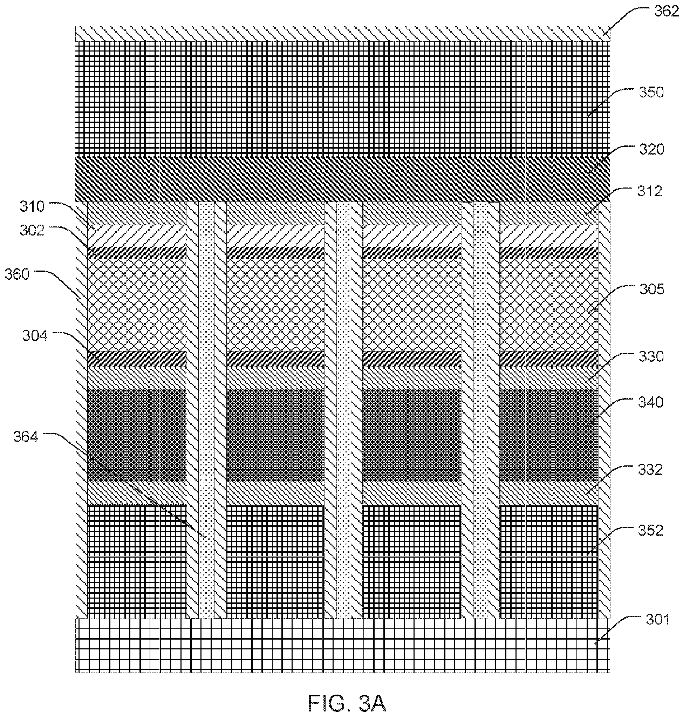

FIG. 2 also illustrates a bitline 250 and a wordline 252, for example. However, it is noted that these features are presented for context and are not necessarily intended to form part of the individual PCM cell 200. However, the bitline 250 and the wordline 252 can form part of a PCM structure. For example, a PCM structure can include a PCM cell as described herein interconnecting an individual bitline and an individual wordline, as illustrated in FIG. 2. In some further examples, a PCM structure can include a plurality of PCM cells electrically coupled to a common bitline or wordline. The conductive bitline and wordline can be made of a variety of conductive materials. Non-limiting examples can include tungsten (W), tungsten nitride (WN), nickel (Ni), tantalum nitride (TaN), platinum (Pt), gold (Au), titanium nitride (TiN), titanium silicon nitride (TiSiN), titanium aluminum nitride (TiAIN), molybdenum nitride (MoN), the like, or a combination thereof. In some examples, the wordline and the bitline can be formed of the same material. In other examples, the wordline and the bitline can be formed of different materials. It is also noted that, in some examples, the wordline of a PCM structure can be oriented in a substantially perpendicular orientiation to the bitline. This is illustrated more clearly in FIGs. 3A-3B illustrating an example PCM device.

Individual PCM cells as described herein can be included in a PCM device to form an array of PCM cells. The PCM device can additionally include an array of wordlines and an array of bitlines. The array of PCM cells can interconnect the array of wordlines and the array of bitlines. Individual PCM cells can be individually addressable.

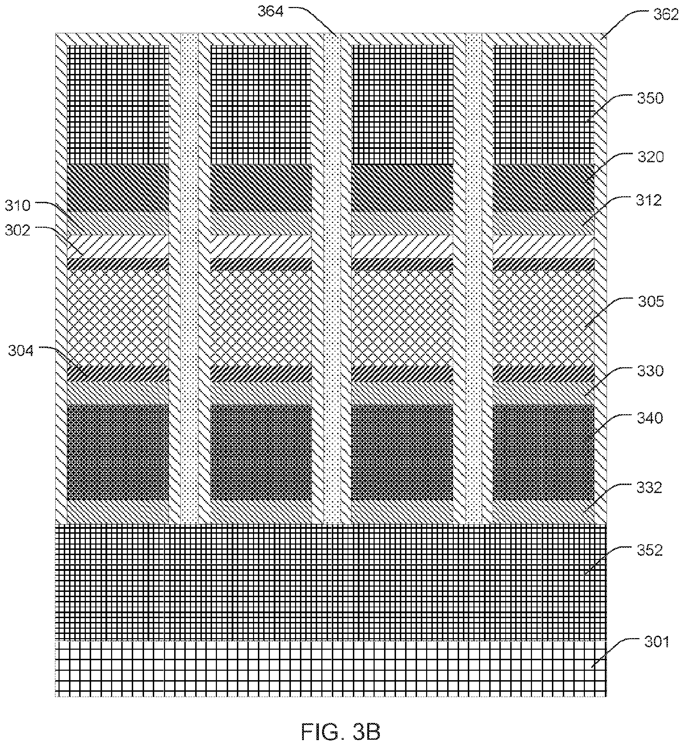

FIGs. 3A-3B illustrates different views of a PCM device 300 having an array of PCM cells as described herein. More specifically, FIG. 3A illustrates a view of a cross-sectional cut along an individual bitline 350 with individual wordlines 352 extending into the page and the bitline 350 oriented perpendicular to the individual wordlines 352. FIG. 3B illustrates a view of a cross-sectional cut along an individual wordline 352 with individual bitlines 350 extending into the page and the wordline 352 oriented perpendicular to the individual bitlines 350. In this particular example of PCM device 300, individual PCM cells include an amorphous CNₓ electrode layer 310, a metal ceramic composite material layer 320, and an upper barrier layer 312 disposed therebetween. The amorphous CNₓ electrode layer 310 and the upper barrier layer 312 can form a first electrode or a CNₓ electrode. The amorphous CNₓ electrode layer 310 can have a gradient composition or a uniform composition, as described elsewhere herein. A bitline 350 is positioned on the metal ceramic composite material layer 320. An upper lamina layer 302 and a lower lamina layer 304 are positioned on opposite sides of a PCM layer 305. The PCM layer is positioned on a second electrode 330. The second electrode 330 is disposed on an SD layer 340. The SD layer 340 is positioned on a third electrode 332. Individual PCM cells are formed on a wordline 352. Individual wordlines 352 are formed on a suitable substrate 301. Any suitable substrate material can be used. For example, the substrate can be a conventional silicon substrate or other bulk substrate including a layer of semiconductive material. The bulk substrate can include, but is not limited to, silicon, silicon-on-insulator (SOI), silicon-on-sapphire (SOS), epitaxial silicon, or the like, or a combination thereof on a base semiconductor foundation, or another semiconductor or optoelectrical material, such as silicon-germanium, germanium, gallium arsenide, indium phosphide, the like, or a combination thereof. The substrate can be doped or undoped.

A dielectric material 364 can be positioned between individual PCM cells to electrically isolate individual PCM cells. In some examples, the dielectric material can include SiO₂ or other suitable dielectric material. It is also noted that a second dielectric material 360 and a third dielectric material 362 can also be used to encapsulate or further isolate individual PCM cells. In some examples, the second dielectric material, the third dielectric material, or both can include silicon nitride (e.g. Si₃N₄ or in general SiₓN_{y}, where x and y represent any suitable relative quantity) or other suitable dielectric material.

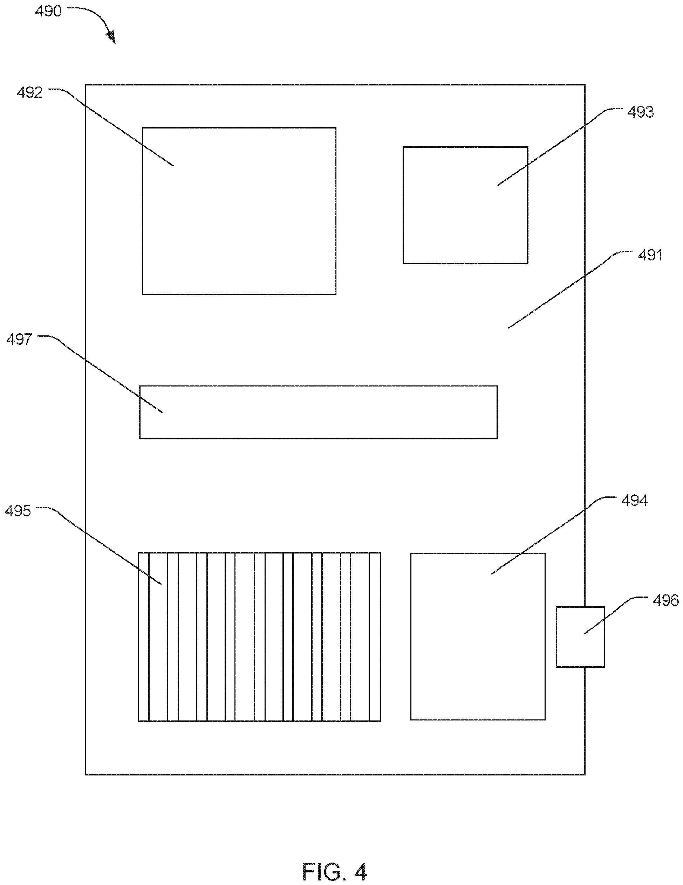

In some examples, a PCM device as described herein can be included in a computing system. A computing system can include a motherboard and a PCM device as described herein that is operably coupled to the motherboard. In one aspect, as illustrated in FIG. 4, a computing system 490 can also include a processor 492, a PCM device 493, a radio 494, a heat sink 495, a port 496, a slot 497, or any other suitable device or component, which can be operably coupled to the motherboard 491. The computing system 490 can comprise any type of computing system, such as a desktop computer, a laptop computer, a tablet computer, a smartphone, a wearable device, a server, etc. Other embodiments need not include all of the features specified in FIG. 4, and may include alternative features not specified in FIG. 4.

Circuitry used in electronic components or devices (e.g. a die) of a PCM device can include hardware, firmware, program code, executable code, computer instructions, and/or software. Electronic components and devices can include a non-transitory computer readable storage medium which can be a computer readable storage medium that does not include signal. In the case of program code execution on programmable computers, the computing systems recited herein may include a processor, a storage medium readable by the processor (including volatile and non-volatile memory and/or storage elements), at least one input device, and at least one output device. Volatile and non-volatile memory and/or storage elements may be a RAM, EPROM, flash drive, optical drive, magnetic hard drive, solid state drive, or other medium for storing electronic data. Node and wireless devices may also include a transceiver module, a counter module, a processing module, and/or a clock module or timer module. One or more programs that may implement or utilize any techniques described herein may use an application programming interface (API), reusable controls, and the like. Such programs may be implemented in a high level procedural or object oriented programming language to communicate with a computer system. However, the program(s) may be implemented in assembly or machine language, if desired. In any case, the language may be a compiled or interpreted language, and combined with hardware implementations.

As described above, the PCM cells described herein can have good programming efficiency. Thus, the present disclosure also describes methods of minimizing a programming current for a PCM cell. The methods can include forming an amorphous CNₓ electrode layer, as described herein, between a PCM material layer and a metal ceramic composite layer. The amorphous CNₓ electrode layer can provide higher resistivity than a carbon electrode layer to minimize a programming current for the PCM cell. Further, in some examples, the amorphous CNₓ electrode layer can include a gradient nitrogen content that minimizes an electrical resistivity at the interface between the amorphous CNₓ electrode layer and a metal ceramic composite material layer. Additionally, or alternatively, an upper barrier layer can be positioned between the amorphous CNₓ electrode layer and the metal ceramic composite material layer to minimize the resistivity at the interface between the amorphous CNₓ electrode layer and a metal ceramic composite material layer. Where an upper barrier layer is employed between the amorphous CNₓ electrode layer and the metal ceramic composite material layer, the amorphous CNₓ electrode layer can have a uniform composition rather than a gradient composition. The various characteristics of these layers are described elsewhere herein.

The present disclosure also describes methods of manufacturing a PCM cell. Generally, the methods of manufacturing can include forming a CNₓ electrode (or first electrode) between a PCM material layer and a metal ceramic composite material layer. (See FIGs. 1A-1C, for example). The CNₓ electrode (or first electrode) can include an amorphous CNₓ electrode layer as described herein.

The CNₓ electrode can have a variety of forms. In some examples, the CNₓ electrode can include a single amorphous CNₓ electrode layer having a gradient composition. In other examples, the CNₓ electrode can include an amorphous CNₓ electrode layer having a uniform composition and an upper barrier layer positioned to contact the metal ceramic composite material layer. It is noted that the particular composition of the CNₓ electrode can affect the number of deposition chambers required to form the CNₓ electrode. For example, in some cases, where the CNₓ electrode includes an upper barrier layer, two separate deposition chambers can be required to deposit the separate amorphous CNₓ electrode layer and the upper barrier layer. However, where the CNₓ electrode includes a single gradient amorphous CNₓ electrode layer, the CNₓ electrode can be formed in a single deposition chamber, for example. In some further examples, the CNₓ electrode can include an amorphous CNₓ electrode layer and an upper barrier layer that have sufficiently similar compositions to allow formation of both layers in a single deposition chamber. In still further examples, the CNₓ electrode can include an amorphous CNₓ electrode layer, an upper barrier layer, and a lower barrier layer. In such examples, the CNₓ electrode can be formed in from 1 to 3 deposition chambers, depending on the specific compositions of each of the layers.

In some examples, the methods of manufacturing a PCM cell can also include forming an upper lamina layer and/or a lower lamina layer on one or more sides (e.g. opposite sides) of the PCM material layer. For example, the upper lamina layer can be formed between the PCM material layer and the CNₓ electrode and the lower lamina layer can be formed between the PCM material layer and a second electrode. In some examples, the second electrode can be formed on a select device layer. In some additional examples, forming the second electrode can include forming a second CNₓ electrode layer. In some further examples, forming the second electrode can include forming a second upper barrier layer, a second lower barrier layer, or both. In some examples, the select device layer can be formed on a third electrode. In some additional examples, forming the third electrode can include forming a third CNₓ electrode layer. In some further examples, forming the third electrode can include forming a third upper barrier layer, a third lower barrier layer, or both. The general features of the various layers of the PCM cell are described elsewhere herein. Further, the various layers of the PCM cell can be formed using any suitable technique, such as chemical vapor deposition (CVD), physical vapor deposition (PVD), atomic layer deposition (ALD), the like, or a combination thereof.

### Examples

In one example there is provided, a phase change memory (PCM) cell comprising a PCM material layer, a metal ceramic composite material layer, and an amorphous carbon nitride (CNₓ) electrode layer disposed between the PCM material layer and the metal ceramic composite material layer.

In one example of a PCM cell, the PCM material layer comprises germanium, antimony, tellurium, silicon, nickel, gallium, arsenic, silver, tin, gold, lead, bismuth, indium, selenium, oxygen, sulphur, nitrogen, carbon, or a combination thereof.

In one example of a PCM cell, the metal ceramic composite material layer comprises tungsten silicon nitride, tantalum silicon nitride, niobium silicon nitride, molybdenum silicon nitride, titanium silicon nitride, carbon nitride, tungsten carbon nitride, doped alpha silicon, doped alpha germanium, or a combination thereof.

In one example of a PCM cell, the metal ceramic composite material layer comprises a metal silicon nitride and the amorphous CNₓ electrode layer is at least 50% amorphous.

In one example of a PCM cell, the metal ceramic composite material layer comprises a metal silicon nitride and the amorphous CNₓ electrode layer is at least 70% amorphous.

In one example of a PCM cell, the metal ceramic composite material layer comprises a metal silicon nitride and the amorphous CNₓ electrode layer is at least 90% amorphous.

In one example of a PCM cell, the amorphous CNₓ electrode layer has an electrical resistivity at room temperature of from about 1 mOhm-cm to about 2000 mOhm-cm.

In one example of a PCM cell, the amorphous CNₓ electrode layer has an electrical resistivity at 650 °C of from about 1 mOhm-cm to about 100 mOhm-cm.

In one example of a PCM cell, the amorphous CNₓ electrode layer has an electrical resistivity at room temperature of from about 1 mOhm-cm to about 2000 mOhm-cm and an electrical resistivity at 650 °C of from about 1 mOhm-cm to about 100 mOhm-cm.

In one example of a PCM cell, nitrogen is present in the amorphous CNₓ electrode layer at an atomic percent (at%) of from about 0.1 at% to about 35 at%.

In one example of a PCM cell, the amorphous CNₓ electrode layer has a thickness of from about 2 nm to about 20 nm.

In one example of a PCM cell, the PCM cell further includes an upper barrier layer positioned between the amorphous CNₓ electrode layer and the metal ceramic composite material layer.

In one example of a PCM cell, the upper barrier layer comprises a first carbon material.

In one example of a PCM cell, the upper barrier layer has a thickness of from 2 nm to 20 nm.

In one example of a PCM cell, the PCM cell further includes a lower barrier layer positioned between the PCM material layer and the amorphous CNₓ electrode layer.

In one example of a PCM cell, the lower barrier layer comprises a carbon material.

In one example of a PCM cell, the lower barrier layer has a thickness of from 2 nm to 20 nm.

In one example of a PCM cell, the amorphous CNₓ electrode layer is in direct contact with the metal ceramic composite material layer.

In one example of a PCM cell, the amorphous CNₓ electrode layer has a gradient concentration of nitrogen of from about 15 at% to about 35 at% N at a PCM material layer side proximate the PCM material layer transitioning to about 0.1 at% to about 1 at% N at an opposite side proximate the metal ceramic composite material layer.

In one example of a PCM cell, the gradient concentration is a substantially linear gradient.

In one example of a PCM cell, the PCM material layer is disposed between the amorphous CNₓ electrode layer and a second electrode.

In one example of a PCM cell, the second electrode comprises carbon, carbon nitride, doped polysilicon, a metal, a conductive metal nitride, a conductive metal silicide, or a combination thereof.

In one example of a PCM cell, the second electrode comprises a second CNₓ electrode layer.

In one example of a PCM cell, the PCM cell further includes a second upper barrier layer positioned between the second CNₓ electrode layer and the PCM material layer.

In one example of a PCM cell, the PCM cell further includes a second lower barrier layer positioned between the second CNₓ electrode layer and a select device layer.

In one example of a PCM cell, the second CNₓ electrode layer has a gradient concentration of nitrogen of from about 15 at% to about 35 at% N at a select device layer side proximate a select device layer transitioning to about 0.1 at% to about 1 at% N at an opposite side proximate the PCM material layer.

In one example of a PCM cell, the second electrode is disposed between the PCM material layer and a select device layer.

In one example of a PCM cell, the select device layer is disposed between the second electrode and a third electrode.

In one example of a PCM cell, the third electrode comprises carbon, carbon nitride, doped polysilicon, a metal, a conductive metal nitride, a conductive metal silicide, or a combination thereof.

In one example of a PCM cell, the third electrode comprises a third CNₓ electrode layer.

In one example of a PCM cell, the PCM cell further includes a third upper barrier layer positioned between the third CNₓ electrode layer and the select device layer.

In one example of a PCM cell, the PCM cell further includes a third lower barrier layer positioned between the third CNₓ electrode layer and an individual wordline.

In one example of a PCM cell, the third CNₓ electrode layer has a gradient concentration of nitrogen of from about 15 at% to about 35 at% N at a wordline side proximate a wordline transitioning to about 0.1 at% to about 1 at% N at an opposite side proximate the select device layer.

In one example of a PCM cell, the PCM cell further includes a lamina layer positioned between the amorphous CNₓ electrode layer and the PCM material layer.

In one example there is provided, a phase change memory (PCM) device, comprises an array of wordlines, an array of bitlines, and an array of PCM cells interconnecting the array of wordlines and the array of bitlines, said array of PCM cells being individually addressable and individually including a PCM material layer, a metal ceramic composite layer, and an amorphous carbon nitride (CNₓ) electrode layer disposed between the PCM material layer and the metal ceramic composite layer.

In one example of a PCM device, the PCM material layer comprises germanium, antimony, tellurium, silicon, nickel, gallium, arsenic, silver, tin, gold, lead, bismuth, indium, selenium, oxygen, sulphur, nitrogen, carbon, or a combination thereof.

In one example of a PCM device, the metal ceramic composite material layer comprises tungsten silicon nitride, tantalum silicon nitride, niobium silicon nitride, molybdenum silicon nitride, titanium silicon nitride, carbon nitride, tungsten carbon nitride, doped alpha silicon, doped alpha germanium, or a combination thereof.

In one example of a PCM device, the metal ceramic composite material layer comprises a metal silicon nitride and the amorphous CNₓ electrode layer is at least 50% amorphous.

In one example of a PCM device, the metal ceramic composite material layer comprises a metal silicon nitride and the amorphous CNₓ electrode layer is at least 70% amorphous.

In one example of a PCM device, the metal ceramic composite material layer comprises a metal silicon nitride and the amorphous CNₓ electrode layer is at least 90% amorphous.

In one example of a PCM device, the amorphous CNₓ electrode layer has an electrical resistivity at room temperature of from about 1 mOhm-cm to about 2000 mOhm-cm.

In one example of a PCM device, the amorphous CNₓ electrode layer has an electrical resistivity at 650 °C of from about 1 mOhm-cm to about 100 mOhm-cm.

In one example of a PCM device, the amorphous CNₓ electrode layer has an electrical resistivity at room temperature of from about 1 mOhm-cm to about 2000 mOhm-cm and an electrical resistivity at 650 °C of from about 1 mOhm-cm to about 100 mOhm-cm.

In one example of a PCM device, nitrogen is present in the amorphous CNₓ electrode layer at an atomic percent (at%) of from about 0.1 at% to about 35 at%.

In one example of a PCM device, the amorphous CNₓ electrode layer has a thickness of from about 2 nm to about 20 nm.

In one example of a PCM device, the PCM device further includes an upper barrier layer positioned between the amorphous CNₓ electrode layer and the metal ceramic composite material layer in individual PCM cells.

In one example of a PCM device, the upper barrier layer comprises a carbon material.

In one example of a PCM device, the upper barrier layer has a thickness of from 2 nm to 20 nm.

In one example of a PCM device, the PCM device further includes a lower barrier layer positioned between the PCM material layer and the amorphous CNₓ electrode layer in individual PCM cells.

In one example of a PCM device, the lower barrier layer comprises a carbon material.

In one example of a PCM device, the lower barrier layer has a thickness of from 2 nm to 20 nm.

In one example of a PCM device, the amorphous CNₓ electrode layer is in direct contact with the metal ceramic composite material layer.

In one example of a PCM device, the amorphous CNₓ electrode layer has a gradient concentration of nitrogen of from about 15 at% to about 35 at% N at a PCM material layer side proximate the PCM material layer transitioning to about 0.1 at% to about 1 at% N at an opposite side proximate the metal ceramic composite material layer.

In one example of a PCM device, the gradient concentration is a substantially linear gradient.

In one example of a PCM device, the PCM material layer is disposed between the amorphous CNₓ electrode layer and a second electrode in individual PCM cells.

In one example of a PCM device, the second electrode comprises carbon, carbon nitride, doped polysilicon, a metal, a conductive metal nitride, a conductive metal silicide, or a combination thereof.

In one example of a PCM device, the second electrode comprises a second CNₓ electrode layer.

In one example of a PCM device, the PCM device further includes a second upper barrier layer positioned between the second CNₓ electrode layer and the PCM material layer.

In one example of a PCM device, the PCM device further includes a second lower barrier layer positioned between the second CNₓ electrode layer and a select device layer.

In one example of a PCM device, the second CNₓ electrode layer has a gradient concentration of nitrogen of from about 15 at% to about 35 at% N at a select device layer side proximate a select device layer transitioning to about 0.1 at% to about 1 at% N at an opposite side proximate the PCM material layer.

In one example of a PCM device, the second electrode is disposed between the PCM material layer and a select device layer in individual PCM cells.

In one example of a PCM device, the select device layer is disposed between the second electrode and a third electrode in individual PCM cells.

In one example of a PCM device, the third electrode comprises carbon, carbon nitride, doped polysilicon, a metal, a conductive metal nitride, a conductive metal silicide, or a combination thereof.

In one example of a PCM device, the third electrode comprises a third CNₓ electrode layer.

In one example of a PCM device, the PCM device further includes a third upper barrier layer positioned between the third CNₓ electrode layer and the select device layer.

In one example of a PCM device, the PCM device further includes a third lower barrier layer positioned between the third CNₓ electrode layer and an individual wordline.

In one example of a PCM device, the third CNₓ electrode layer has a gradient concentration of nitrogen of from about 15 at% to about 35 at% N at a wordline side proximate a wordline transitioning to about 0.1 at% to about 1 at% N at an opposite side proximate the select device layer.

In one example of a PCM device, the PCM device further includes a lamina layer positioned between the amorphous CNₓ electrode layer and the PCM material layer in individual PCM cells.

In one example of a PCM device, the array of bitlines and the array of wordlines are oriented substantially perpendicular to one another.

In one example of a PCM device, the amorphous CNₓ electrode layer of individual PCM cells is positioned between the PCM material layer and an individual bitline.

In one example of a PCM device, the PCM material layer of individual PCM cells is positioned between the amorphous CNₓ electrode layer and an individual wordline.

In one example there is provided, a computing system, comprising a motherboard, and a PCM memory device as described herein operably coupled to the motherboard.

In one example of a computing system, the computing system comprises a desktop computer, a laptop computer, a tablet, a smartphone, a wearable device, a server, or a combination thereof.

In one example of a computing system, the computing system further comprises a processor, a memory device, a heat sink, a radio, a slot, a port, or a combination thereof operably coupled to the motherboard.

In one example there is provided, a method of minimizing a programming current for a phase change memory (PCM) cell, comprising depositing an amorphous carbon nitride (CNₓ) electrode layer between a PCM material layer and a metal ceramic composite layer.

In one example of a method of minimizing a programming current for a PCM cell, the amorphous CNx electrode layer has an electrical resistivity at room temperature of from about 1 mOhm-cm to about 2000 mOhm-cm and an electrical resistivity at 650 °C of from about 1 mOhm-cm to about 100 mOhm-cm.

In one example of a method of minimizing a programming current for a PCM cell, the metal ceramic composite material layer comprises tungsten silicon nitride, tantalum silicon nitride, niobium silicon nitride, molybdenum silicon nitride, titanium silicon nitride, carbon nitride, tungsten carbon nitride, doped alpha silicon, doped alpha germanium, or a combination thereof.

In one example of a method of minimizing a programming current for a PCM cell, nitrogen is present in the amorphous CNₓ electrode layer at an atomic percent (at%) of from about 0.1 at% to about 35 at%.

In one example of a method of minimizing a programming current for a PCM cell, the amorphous CNₓ electrode layer has a thickness of from about 2 nm to about 20 nm.

In one example of a method of minimizing a programming current for a PCM cell, the method further includes disposing an upper barrier layer between the amorphous CNₓ electrode layer and the metal ceramic composite material layer.

In one example of a method of minimizing a programming current for a PCM cell, the upper barrier layer comprises a carbon material.

In one example of a method of minimizing a programming current for a PCM cell, the method further includes disposing a lower barrier layer between the PCM material layer and the amorphous CNₓ electrode layer.

In one example of a method of minimizing a programming current for a PCM cell, the lower barrier layer comprises a carbon material.

In one example of a method of minimizing a programming current for a PCM cell, the amorphous CNₓ electrode layer is in direct contact with the metal ceramic composite material layer.

In one example of a method of minimizing a programming current for a PCM cell, the amorphous CNₓ electrode layer has a gradient concentration of nitrogen of from about 15 at% to about 35 at% N at a PCM material layer side proximate the PCM material layer transitioning to about 0.1 at% to about 1 at% N at an opposite side proximate the metal ceramic composite material layer.

In one example of a method of minimizing a programming current for a PCM cell, the gradient concentration is a substantially linear gradient.

In one example there is provided, a method of manufacturing a phase change memory (PCM) cell, comprising forming a carbon nitride (CNₓ) electrode between a PCM material layer and a metal ceramic composite material layer, the CNₓ electrode comprising an amorphous CNₓ electrode layer.

In one example of a method of manufacturing a PCM cell, the amorphous CNx electrode layer has an electrical resistivity at room temperature of from about 1 mOhm-cm to about 2000 mOhm-cm and an electrical resistivity at 650 °C of from about 1 mOhm-cm to about 100 mOhm-cm.

In one example of a method of manufacturing a PCM cell, the PCM material layer comprises germanium, antimony, tellurium, silicon, nickel, gallium, arsenic, silver, tin, gold, lead, bismuth, indium, selenium, oxygen, sulphur, nitrogen, carbon, or a combination thereof.

In one example of a method of manufacturing a PCM cell, the CNₓ electrode comprises an amorphous CNₓ electrode layer and an upper barrier layer, wherein the upper barrier layer is positioned between the amorphous CNₓ electrode layer and the metal ceramic composite material layer.

In one example of a method of manufacturing a PCM cell, nitrogen is present in the amorphous CNₓ electrode layer at an atomic percent (at%) of from about 0.1 at% to about 35 at%.

In one example of a method of manufacturing a PCM cell, the amorphous CNₓ electrode layer has a thickness of from about 2 nm to about 20 nm.

In one example of a method of manufacturing a PCM cell, the upper barrier layer comprises a carbon material.

In one example of a method of manufacturing a PCM cell, the upper barrier layer has a thickness of from 2 nm to 20 nm.

In one example of a method of manufacturing a PCM cell, the CNₓ electrode is deposited in two separate deposition chambers.

In one example of a method of manufacturing a PCM cell, the method further includes forming a lower barrier layer between the PCM material layer and the amorphous CNₓ electrode layer.

In one example of a method of manufacturing a PCM cell, the lower barrier layer comprises a carbon material.

In one example of a method of manufacturing a PCM cell, the lower barrier layer has a thickness of from about 2 nm to about 20 nm.

In one example of a method of manufacturing a PCM cell, the CNₓ electrode is deposited in two separate deposition chambers.

In one example of a method of manufacturing a PCM cell, the CNₓ electrode consists of an amorphous CNₓ electrode layer, and the metal ceramic composite material layer is formed in direct contact with the amorphous CNₓ electrode layer.

In one example of a method of manufacturing a PCM cell, the amorphous CNₓ electrode layer has a gradient concentration of nitrogen of from about 15 at% to about 35 at% N at a PCM material layer side proximate the PCM material layer transitioning to about 0.1 at% to about 1 at% N at an opposite side proximate the metal ceramic composite material layer.

In one example of a method of manufacturing a PCM cell, the gradient concentration is a substantially linear gradient.

In one example of a method of manufacturing a PCM cell, the CNₓ electrode is deposited in a single deposition chamber.

In one example of a method of manufacturing a PCM cell, the method further includes forming a lamina layer between the PCM material layer and the CNₓ electrode.

In one example of a method of manufacturing a PCM cell, the method further includes forming the PCM material layer on a second electrode.

In one example of a method of manufacturing a PCM cell, the second electrode comprises a second CNₓ electrode layer.

In one example of a method of manufacturing a PCM cell, the method further includes forming a second upper barrier layer positioned between the second CNₓ electrode layer and the PCM material layer.

In one example of a method of manufacturing a PCM cell, the method further includes forming a second lower barrier layer positioned between the second CNₓ electrode layer and a select device layer.

In one example of a method of manufacturing a PCM cell, the second CNₓ electrode layer has a gradient concentration of nitrogen of from about 15 at% to about 35 at% N at a select device layer side proximate a select device layer transitioning to about 0.1 at% to about 1 at% N at an opposite side proximate the PCM material layer.

In one example of a method of manufacturing a PCM cell, the method further includes forming the second electrode on a select device layer.

In one example of a method of manufacturing a PCM cell, the method further includes forming the select device layer on a third electrode.

In one example of a method of manufacturing a PCM cell, the third electrode comprises a third CNₓ electrode layer.

In one example of a method of manufacturing a PCM cell, the method further includes forming a third upper barrier layer positioned between the third CNₓ electrode layer and the select device layer.

In one example of a method of manufacturing a PCM cell, the method further includes forming a third lower barrier layer positioned between the third CNₓ electrode layer and an individual wordline.

In one example of a method of manufacturing a PCM cell, the third CNₓ electrode layer has a gradient concentration of nitrogen of from about 15 at% to about 35 at% N at a wordline side proximate a wordline transitioning to about 0.1 at% to about 1 at% N at an opposite side proximate the select device layer.

While the forgoing examples are illustrative of the principles of the present technology in one or more particular applications, it will be apparent to those of ordinary skill in the art that numerous modifications in form, usage and details of implementation can be made without the exercise of inventive faculty, and without departing from the scope of the invention as defined by the claims.

## Claims

1. A phase change memory , PCM, cell (100), comprising:
a PCM material layer (105);
a metal ceramic composite material layer (120); and
an amorphous carbon nitride (CNₓ) electrode layer (110) disposed between the PCM material layer and the metal ceramic composite material layer.

2. The PCM cell of claim 1, wherein the PCM material layer comprises germanium, antimony, tellurium, silicon, nickel, gallium, arsenic, silver, tin, gold, lead, bismuth, indium, yttrium, selenium, boron, scandium, oxygen, sulphur, nitrogen, carbon, or a combination thereof, and the metal ceramic composite material layer comprises tungsten silicon nitride, tantalum silicon nitride, niobium silicon nitride, molybdenum silicon nitride, titanium silicon nitride, carbon nitride, tungsten carbon nitride, doped alpha silicon, doped alpha germanium, or a combination thereof.

3. The PCM cell of any one of claims 1 and 2, wherein the metal ceramic composite material layer comprises a metal silicon nitride, the amorphous CNₓ electrode layer is at least 50% amorphous, at least 70% amorphous, or at least 90% amorphous, and the amorphous CNₓ electrode layer has an electrical resistivity at room temperature of from about 1 mOhm-cm to about 2000 mOhm-cm.

4. The PCM cell of any one of claims 1-3, wherein the amorphous CNₓ electrode layer has an electrical resistivity at 650 °C of from about 1 mOhm-cm to about 100 mOhm-cm, or the amorphous CNₓ electrode layer has an electrical resistivity at room temperature of from about 1 mOhm-cm to about 2000 mOhm-cm and an electrical resistivity at 650 °C of from about 1 mOhm-cm to about 100 mOhm-cm.

5. The PCM cell of any one of claims 1-3, wherein nitrogen is present at an atomic percent (at%) of from about 0.1 at% to about 35 at% in the amorphous CNₓ electrode layer, and wherein the amorphous CNₓ electrode layer has a gradient nitrogen composition.

6. The PCM cell of any one of claims 1-3, further comprising at least one of an upper barrier layer positioned between the amorphous CNₓ electrode layer and the metal ceramic composite material layer, or a lower barrier layer positioned between the PCM material layer and the amorphous CNₓ electrode layer.

7. The PCM cell of claim 6, wherein said at least one of the upper barrier layer and the lower barrier layer comprises a carbon material.

8. The PCM cell of claim 6, wherein said at least one of the upper barrier layer and the lower barrier layer has a thickness of from 2 nm to 20 nm.

9. The PCM cell of any one of claims 1-3, wherein the amorphous CNₓ electrode layer is in direct contact with the metal ceramic composite material layer.

10. The PCM cell of any one of claims 1-3, wherein the amorphous CNₓ electrode layer has a gradient concentration of nitrogen of from about 15 at% to about 35 at% N at a PCM material layer side proximate the PCM material layer transitioning to about 0.1 at% to about 1 at% N at an opposite side proximate the metal ceramic composite material layer, and wherein the PCM material layer is disposed between the amorphous CNₓ electrode layer and a second electrode, and the second electrode comprises carbon, carbon nitride, doped polysilicon, a metal, a conductive metal nitride, a conductive metal silicide, or a combination thereof.

11. A phase change memory (PCM) device, comprising:
an array of wordlines (252);
an array of bitlines (250); and
an array of PCM cells (200) interconnecting the array of wordlines and the array of bitlines, said PCM cells being individually addressable and individually comprising:
a PCM material layer (205), a metal ceramic composite layer (220), and
an amorphous carbon nitride (CNx) electrode layer (210) disposed between the PCM
material layer and the metal ceramic composite layer.

12. The device of claim 11, wherein the PCM material layer comprises germanium, antimony, tellurium, silicon, nickel, gallium, arsenic, silver, tin, gold, lead, bismuth, indium, yttrium, selenium, boron, scandium, oxygen, sulphur, nitrogen, carbon, or a combination thereof, and the metal ceramic composite material layer comprises tungsten silicon nitride, tantalum silicon nitride, niobium silicon nitride, molybdenum silicon nitride, titanium silicon nitride, carbon nitride, tungsten carbon nitride, doped alpha silicon, doped alpha germanium, or a combination thereof.

13. A method of manufacturing a phase change memory (PCM) cell (100), comprising forming a carbon nitride (CNₓ) electrode (110) between a PCM material layer (105) and a metal ceramic composite material layer (120), the CNₓ electrode comprising an amorphous CNₓ electrode layer.

14. The method of claim 13, wherein the amorphous CNₓ electrode layer has an electrical resistivity at room temperature of from about 1 mOhm-cm to about 2000 mOhm-cm and an electrical resistivity at 650 °C of from about 1 mOhm-cm to about 100 mOhm-cm.

15. The method of any one of claims 13 and 14, wherein the PCM material layer comprises germanium, antimony, tellurium, silicon, nickel, gallium, arsenic, silver, tin, gold, lead, bismuth, indium, selenium, oxygen, sulphur, nitrogen, carbon, or a combination thereof, and wherein the CNₓ electrode comprises an amorphous CNₓ electrode layer and an upper barrier layer, wherein the upper barrier layer is positioned between the amorphous CNx electrode layer and the metal ceramic composite material layer.

## Patentansprüche

1. Phasenwechselspeicher(PCM)-Zelle (100), umfassend:
eine PCM-Materialschicht (105);
eine metallkeramische Verbundmaterialschicht (120); und
eine amorphe Kohlenstoffnitrid(CN_{X})-Elektrodenschicht (110), die zwischen der PCM-Materialschicht und der metallkeramischen Verbundmaterialschicht angeordnet ist.

2. PCM-Zelle gemäß Anspruch 1, wobei die PCM-Materialschicht Germanium, Antimon, Tellur, Silicium, Nickel, Gallium, Arsen, Silber, Zinn, Gold, Blei, Bismut, Indium, Yttrium, Selen, Bor, Scandium, Sauerstoff, Schwefel, Stickstoff, Kohlenstoff oder eine Kombination davon umfasst und die metallkeramische Verbundmaterialschicht Wolframsiliciumnitrid, Tantalsiliciumnitrid, Niobsiliciumnitrid, Molybdänsiliciumnitrid, Titansiliciumnitrid, Kohlenstoffnitrid, Wolframkohlenstoffnitrid, dotiertes alpha-Silicium, dotiertes alpha-Germanium oder eine Kombination davon umfasst.

3. PCM-Zelle gemäß einem der Ansprüche 1 und 2, wobei die metallkeramische Verbundmaterialschicht ein Metallsiliciumnitrid umfasst, die amorphe CN_{X}-Elektrodenschicht wenigstens 50 % amorph, wenigstens 70 % amorph oder wenigstens 90 % amorph ist und die amorphe CNₓ-Elektrodenschicht einen spezifischen elektrischen Widerstand bei Raumtemperatur von etwa 1 mOhm-cm bis etwa 2000 mOhm-cm aufweist.

4. PCM-Zelle gemäß einem der Ansprüche 1-3, wobei die amorphe CNₓ-Elektrodenschicht einen spezifischen elektrischen Widerstand bei 650 °C von etwa 1 mOhm-cm bis etwa 100 mOhm-cm aufweist oder die amorphe CN_{X}-Elektrodenschicht einen spezifischen elektrischen Widerstand bei Raumtemperatur von etwa 1 mOhm-cm bis etwa 2000 mOhm-cm und einen spezifischen elektrischen Widerstand bei 650 °C von etwa 1 mOhm-cm bis etwa 100 mOhm-cm aufweist.

5. PCM-Zelle gemäß einem der Ansprüche 1-3, wobei in der amorphen CNₓ-Elektrodenschicht Stickstoff in einer Atomprozentmenge (at-%) von etwa 0,1 at-% bis etwa 35 at-% vorhanden ist und wobei die amorphe CN_{X}-Elektrodenschicht eine Gradienten-Stickstoffzusammensetzung aufweist.

6. PCM-Zelle gemäß einem der Ansprüche 1-3, ferner umfassend wenigstens eine von einer oberen Barriereschicht, die zwischen der amorphen CN_{X}-Elektrodenschicht und der metallkeramischen Verbundmaterialschicht angeordnet ist, und einer unteren Barriereschicht, die zwischen der PCM-Materialschicht und der amorphen CNₓ-Elektrodenschicht angeordnet ist.

7. PCM-Zelle gemäß Anspruch 6, wobei die wenigstens eine von der oberen Barriereschicht und der unteren Barriereschicht ein Kohlenstoffmaterial umfasst.

8. PCM-Zelle gemäß Anspruch 6, wobei die wenigstens eine von der oberen Barriereschicht und der unteren Barriereschicht eine Dicke von 2 nm bis 20 nm aufweist.

9. PCM-Zelle gemäß einem der Ansprüche 1-3, wobei die amorphe CNₓ-Elektrodenschicht in direktem Kontakt mit der metallkeramischen Verbundmaterialschicht steht.

10. PCM-Zelle gemäß einem der Ansprüche 1-3, wobei die amorphe CNₓ-Elektrodenschicht eine Gradientenkonzentration von Stickstoff von etwa 15 at-% bis etwa 35 at-% N an einer PCM-Materialschichtseite nahe der PCM-Materialschicht, die zu etwa 0,1 at-% bis etwa 1 at-% N an einer gegenüberliegenden Seite nahe der metallkeramischen Verbundmaterialschicht übergeht, aufweist, und wobei die PCM-Materialschicht zwischen der amorphen CNₓ-Elektrodenschicht und einer zweiten Elektrode angeordnet ist und die zweite Elektrode Kohlenstoff, Kohlenstoffnitrid, dotiertes Polysilicium, ein Metall, ein leitfähiges Metallnitrid, ein leitfähiges Metallsilicid oder eine Kombination davon umfasst.

11. Phasenwechselspeicher(PCM)-Vorrichtung, umfassend:
ein Feld von Wortleitungen (252);
ein Feld von Bitleitungen (250); und
ein Feld von PCM-Zellen (200), die das Feld von Wortleitungen und das Feld von Bitleitungen verbinden,
wobei die PCM-Zellen einzeln ansprechbar sind und jeweils umfassen:
eine PCM-Materialschicht (205);
eine metallkeramische Verbundmaterialschicht (220); und
eine amorphe Kohlenstoffnitrid(CN_{X}) - Elektrodenschicht (210), die zwischen der PCM-Materialschicht und der metallkeramischen Verbundmaterialschicht angeordnet ist.

12. Vorrichtung gemäß Anspruch 11, wobei die PCM-Materialschicht Germanium, Antimon, Tellur, Silicium, Nickel, Gallium, Arsen, Silber, Zinn, Gold, Blei, Bismut, Indium, Yttrium, Selen, Bor, Scandium, Sauerstoff, Schwefel, Stickstoff, Kohlenstoff oder eine Kombination davon umfasst und die metallkeramische Verbundmaterialschicht Wolframsiliciumnitrid, Tantalsiliciumnitrid, Niobsiliciumnitrid, Molybdänsiliciumnitrid, Titansiliciumnitrid, Kohlenstoffnitrid, Wolframkohlenstoffnitrid, dotiertes alpha-Silicium, dotiertes alpha-Germanium oder eine Kombination davon umfasst.

13. Verfahren zur Herstellung einer Phasenwechselspeicher(PCM)-Zelle (100), umfassend Bilden einer Kohlenstoffnitrid(CNₓ)-Elektroden (110) zwischen einer PCM-Materialschicht (105) und einer metallkeramischen Verbundmaterialschicht (120), wobei die CNₓ-Elektrode eine amorphe CNₓ-Elektrodenschicht umfasst.

14. Verfahren gemäß Anspruch 13, wobei die amorphe CNₓ-Elektrodenschicht einen spezifischen elektrischen Widerstand bei Raumtemperatur von etwa 1 mOhm-cm bis etwa 2000 mOhm-cm und einen spezifischen elektrischen Widerstand bei 650 °C von etwa 1 mOhm-cm bis etwa 100 mOhm-cm aufweist.

15. Verfahren gemäß einem der Ansprüche 13 und 14, wobei die PCM-Materialschicht Germanium, Antimon, Tellur, Silicium, Nickel, Gallium, Arsen, Silber, Zinn, Gold, Blei, Bismut, Indium, Selen, Sauerstoff, Schwefel, Stickstoff, Kohlenstoff oder eine Kombination davon umfasst und wobei die CNₓ-Elektrode eine amorphe CNₓ-Elektrodenschicht und eine obere Barriereschicht umfasst, wobei die obere Barriereschicht zwischen der amorphen CNₓ-Elektrodenschicht und der metallkeramischen Verbundmaterialschicht angeordnet ist.

## Revendications

1. Cellule (100) de mémoire à changement de phase, PCM, comprenant :
une couche (105) de matériau de PCM ;
une couche (120) de matériau composite de céramique et de métal ; et
une couche (110) d'électrode de nitrure de carbone amorphe (CNₓ) disposée entre la couche de matériau de PCM et la couche de matériau composite de céramique et de métal.

2. Cellule de PCM selon la revendication 1, la couche de matériau de PCM comprenant du germanium, de l'antimoine, du tellure, du silicium, du nickel, du gallium, de l'arsenic, de l'argent, de l'étain, de l'or, du plomb, du bismuth, de l'indium, de l'yttrium, du sélénium, du bore, du scandium, de l'oxygène, du soufre, de l'azote, du carbone ou une combinaison correspondante, et la couche de matériau composite de céramique et de métal comprenant du nitrure de tungstène silicium, du nitrure de tantale silicium, du nitrure de niobium silicium, du nitrure de molybdène silicium, du nitrure de titane silicium, du nitrure de carbone, du nitrure de tungstène carbone, du silicium alpha dopé, du germanium alpha dopé ou une combinaison correspondante.

3. Cellule de PCM selon l'une quelconque des revendications 1 et 2, la couche de matériau composite de céramique et de métal comprenant un nitrure de silicium et de métal, la couche d'électrode de CNₓ amorphe étant au moins 50 % amorphe, au moins 70 % amorphe, ou au moins 90 % amorphe, et la couche d'électrode de CNₓ amorphe possédant une résistivité électrique à température ambiante allant d'environ 1 mOhm-cm à environ 2 000 mOhm-cm.

4. Cellule de PCM selon l'une quelconque des revendications 1 à 3, la couche d'électrode de CNₓ amorphe possédant une résistivité électrique à 650 °C allant d'environ 1 mOhm-cm à environ 100 mOhm-cm, ou la couche d'électrode de CNₓ amorphe possédant une résistivité électrique à température ambiante allant d'environ 1 mOhm-cm à environ 2 000 mOhm-cm et une résistivité électrique à 650 °C allant d'environ 1 mOhm-cm à environ 100 mOhm-cm.

5. Cellule de PCM selon l'une quelconque des revendications 1 à 3, de l'azote étant présent à raison d'un pourcentage atomique (% at) allant d'environ 0,1 % at à environ 35 % at dans la couche d'électrode de CN_{X} amorphe, et la couche d'électrode de CN_{X} amorphe possédant une composition en azote à gradient.

6. Cellule de PCM selon l'une quelconque des revendications 1 à 3, comprenant en outre au moins l'une parmi une couche barrière supérieure positionnée entre la couche d'électrode de CN_{X} amorphe et la couche de matériau composite de céramique et de métal, et une couche barrière inférieure positionnée entre la couche de matériau de PCM et la couche d'électrode de CN_{X} amorphe.

7. Cellule de PCM selon la revendication 6, ladite au moins une parmi la couche barrière supérieure et la couche barrière inférieure comprenant un matériau de carbone.

8. Cellule de PCM selon la revendication 6, ladite au moins une parmi la couche barrière supérieure et la couche barrière inférieure possédant une épaisseur allant de 2 nm à 20 nm.

9. Cellule de PCM selon l'une quelconque des revendications 1 à 3, la couche d'électrode de CN_{X} amorphe étant en contact direct avec la couche de matériau composite de céramique et de métal.

10. Cellule de PCM selon l'une quelconque des revendications 1 à 3, la couche d'électrode de CN_{X} amorphe possédant une concentration à gradient d'azote allant d'environ 15 % at à environ 35 % at de N au niveau d'un côté de couche de matériau de PCM à proximité de la couche de matériau de PCM en transition jusqu'à environ 0,1 % at à environ 1 % at de N au niveau d'un côté opposé à proximité de la couche de matériau composite de céramique et de métal, et la couche de matériau de PCM étant disposée entre la couche d'électrode de CN_{X} amorphe et une deuxième électrode, et la deuxième électrode comprenant du carbone, du nitrure de carbone, du polysilicium dopé, un métal, un nitrure de métal conducteur, un siliciure de métal conducteur ou une combinaison correspondante.

11. Dispositif de mémoire à changement de phase (PCM), comprenant :
un réseau de lignes de mots (252) ;
un réseau de lignes de bits (250) ; et
un réseau de cellules (200) de PCM interconnectant le réseau de lignes de mots et le réseau de lignes de bits,
lesdites cellules de PCM étant individuellement adressables et comprenant individuellement :
une couche (205) de matériau de PCM,
une couche (220) de composite de céramique et de métal, et
une couche (210) d'électrode de nitrure de carbone amorphe (CNₓ) disposée entre la couche de matériau de PCM et la couche de composite de céramique et de métal.

12. Dispositif selon la revendication 11, la couche de matériau de PCM comprenant du germanium, de l'antimoine, du tellure, du silicium, du nickel, du gallium, de l'arsenic, de l'argent, de l'étain, de l'or, du plomb, du bismuth, de l'indium, de l'yttrium, du sélénium, du bore, du scandium, de l'oxygène, du soufre, de l'azote, du carbone ou une combinaison correspondante, et la couche de matériau composite de céramique et de métal comprenant du nitrure de tungstène silicium, du nitrure de tantale silicium, du nitrure de niobium silicium, du nitrure de molybdène silicium, du nitrure de titane silicium, du nitrure de carbone, du nitrure de tungstène carbone, du silicium alpha dopé, du germanium alpha dopé ou une combinaison correspondante.

13. Procédé de fabrication d'une cellule (100) de mémoire à changement de phase (PCM), comprenant la formation d'une électrode (110) de nitrure de carbone (CNₓ) entre une couche (105) de matériau de CPM et une couche (120) de matériau composite de céramique et de métal, l'électrode de CN_{X} comprenant une couche d'électrode de CN_{X} amorphe.

14. Procédé selon la revendication 13, la couche d'électrode de CN_{X} amorphe possédant une résistivité électrique à température ambiante allant d'environ 1 mOhm-cm à environ 2 000 mOhm-cm et une résistivité électrique à 650 °C allant d'environ 1 mOhm-cm à environ 100 mOhm-cm.

15. Procédé selon l'une quelconque des revendications 13 et 14, la couche de matériau de PCM comprenant du germanium, de l'antimoine, du tellure, du silicium, du nickel, du gallium, de l'arsenic, de l'argent, de l'étain, de l'or, du plomb, du bismuth, de l'indium, du sélénium, de l'oxygène, du soufre, de l'azote, du carbone ou une combinaison correspondante, et l'électrode de CN_{X} comprenant une couche d'électrode de CN_{X} amorphe et une couche barrière supérieure, la couche barrière supérieure étant positionnée entre la couche d'électrode de CN_{X} amorphe et la couche de matériau composite de céramique et de métal.
